# EUROPEAN PATENT APPLICATION

(11) **EP 2 058 863 A2**
(43) Date of publication of application: **13.05.2009**
(21) Application number: 08153689.8
(22) Date of filing: 31.03.2008
(51) Int. Cl.: H01L 31/0216

(54) **Photovoltaics with interferometric masks**

(30) Priority: 04.12.2007 US 950392; 07.11.2007 US 2198 P
(71) Applicant: QUALCOMM MEMS Technologies, Inc., San Diego, CA 92121 (US)
(72) Inventor: Kothari, Manish, Cupertino, CA 95014 (US); Khazeni, Kasra, San Jose, CA 95120 (US)
(74) Representative: Witte, Weller & Partner

(57) **Abstract**

An interferometric mask covering the front electrodes of a photovoltaic device is disclosed. Such an interferometric mask may reduce reflections of incident light from the electrodes. In various embodiments, the mask reduces reflections so that a front electrode pattern appears similar in color to adjacent regions of visible photovoltaic active material.

## Description

### CROSS-REFERENCE TO RELATED APPLICATIONS

This application claims priority under 35 U.S.C. § 119(e) to United States Provisional Application Serial No. 61/002,198 filed on November 7, 2007, titled "BLACK PHOTOVOLTAICS USING INTERFEROMETRIC MODULATORS " (Atty. Docket No. QCO.235PR), the disclosure of which is hereby expressly incorporated by reference in its entirety.

### BACKGROUND

### Field of the Invention

The present invention relates generally to the field of optoelectronic transducers that convert optical energy into electrical energy, such as for example photovoltaic cells.

### Description of the Related Technology

For over a century fossil fuel such as coal, oil, and natural gas has provided the main source of energy in the United States. The need for alternative sources of energy is increasing. Fossil fuels are a non-renewable source of energy that is depleting rapidly. The large scale industrialization of developing nations such as India and China has placed a considerable burden on the available fossil fuel. In addition, geopolitical issues can quickly affect the supply of such fuel. Global warming is also of greater concern in recent years. A number of factors are thought to contribute to global warming; however, widespread use of fossil fuels is presumed to be a main cause of global warming. Thus there is an urgent need to find a renewable and economically viable source of energy that is also environmentally safe. Solar energy is an environmentally safe renewable source of energy that can be converted into other forms of energy such as heat and electricity.

Photovoltaic (PV) cells convert optical energy to electrical energy and thus can be used to convert solar energy into electrical power. Photovoltaic solar cells can be made very thin and modular. PV cells can range in size from a few millimeters to 10's of centimeters. The individual electrical output from one PV cell may range from a few milliwatts to a few watts. Several PV cells may be connected electrically and packaged in arrays to produce sufficient amount of electricity. PV cells can be used in wide range of applications such as providing power to satellites and other spacecraft, providing electricity to residential and commercial properties, charging automobile batteries, etc.

While PV devices have the potential to reduce reliance upon hydrocarbon fuels, the widespread use of PV devices has been hindered by inefficiency and aesthetic concerns. Accordingly, improvements in either of these aspects could increase usage of PV devices.

### SUMMARY OF CERTAIN INVENTIVE ASPECTS

Certain embodiments of the invention include photovoltaic cells or devices integrated with interferometric masks to darken all or part of the cell or device so as to appear dark or black to a viewer. Such interferometrically masked photovoltaic devices may have more uniform color, making them more aesthetically pleasing and therefore more useful in building or architectural applications. In various embodiments, one or more optical resonant cavities and/or optical resonant layers is included in the photovoltaic device, and particularly on a light-incident or front side of a photovoltaic material, to mask a reflective electrode that may be on the front surface of a photovoltaic device. The optical resonant cavities and/or layers may comprise transparent non-conducting materials such as dielectrics, transparent conducting material, air gaps, and combinations thereof. Other embodiments are also possible.

In one embodiment, a photovoltaic device defining a front side on which light is incident and a back side opposite the front side is described. The photovoltaic device includes a photovoltaic active layer and a conductor on the front side of the photovoltaic active layer. An interferometric mask is patterned to cover the front side of the conductor.

In another embodiment, a photovoltaic device includes a photovoltaic material and a conductor in front of the photovoltaic material. The photovoltaic device further includes an optical interferometric cavity in front of the photovoltaic material and the conductor. The cavity includes a reflective surface in front of the photovoltaic material, an optical resonant cavity in front of the reflective surface, and an absorber in front of the optical resonant cavity. A visible color across the front side of the photovoltaic device, including portions of the photovoltaic material and the metallic conductor, is substantially uniform.

In another embodiment, a photovoltaic device includes means for generating an electrical current from incident light on an incident side of said means, means for conducting the generated electrical current, and means for interferometrically masking said conducting means from the incident side of the photovoltaic device.

In another embodiment, a method of manufacturing a photovoltaic device is provided. The method includes providing a photovoltaic generator with a photovoltaic active layer, a patterned front side conductor and a backside conductor. A plurality of layers is formed over the photovoltaic generator. One or more of the plurality of layers is patterned to define an interferometric modulator covering the patterned front side conductor.

### BRIEF DESCRIPTION OF THE DRAWINGS

Example embodiments disclosed herein are illustrated in the accompanying schematic drawings, which are for illustrative purposes only.

FIG. 1 schematically illustrates a theoretical optical interferometric cavity.

FIG. 2 schematically illustrates a plurality of layers forming one implementation of an optical interferometric modulator.

FIG. 3A is a block diagram of an interferometric modulator ("IMOD") stack, similar to that of FIG. 2 comprising an absorber layer, an optical resonant cavity, and a reflector.

FIG. 3B schematically illustrates an IMOD where the optical cavity includes an air gap formed by posts or pillars between the absorber and reflector layers.

FIG. 3C illustrates an embodiment of an IMOD, wherein the optical resonant cavity can be adjusted electromechanically in an "open" state.

FIG. 3D illustrates an IMOD, wherein the optical resonant cavity can be adjusted electromechanically in a "closed" state.

FIG. 4 shows the total reflection versus wavelength of an interferometric light modulator with an optical cavity configured to reflect yellow for normally incident and reflected light.

FIG. 5 shows the total reflection versus wavelength with an optical cavity configured to minimize visible reflections for normally incident and reflected light.

FIG. 6 shows the total reflection versus wavelength of an interferometric light modulator like that of FIG. 5 when the angle of incidence or view angle is approximately 30 degrees to normal.

FIG. 7 schematically illustrates a photovoltaic cell comprising a p-n junction.

FIG. 8 is a block diagram that schematically illustrates a photocell comprising a deposited thin film photovoltaic active material.

FIGS. 9A and 9B are schematic plan and isometric sectional views depicting an exemplary solar photovoltaic device with visible reflective electrodes on the front side.

FIGS. 10A-10G are schematic cross-sectional views illustrating steps in a process of manufacturing an embodiment of an interferometric modulator (IMOD) mask integrated with a photovoltaic device, where the IMOD mask is patterned together with photovoltaic device front electrodes.

FIG. 10H is a schematic cross-sectional view of the photovoltaic device of FIG. 10G after formation of a protective film over the IMOD mask.

FIGS. 11A-D are schematic cross-sectional views illustrating steps of adding an IMOD mask over a photovoltaic device in accordance with another embodiment, wherein layer(s) defining a optical resonant cavity for the IMOD mask remain unpatterned.

FIG. 12 is a schematic cross-sectional view of a photovoltaic device with an IMOD mask covering electrodes in accordance with another embodiment, wherein the IMOD mask comprises layers that are patterned to be slightly wider than the photovoltaic device front electrodes.

FIGS. 13A-13E are schematic cross-sectional views illustrating steps in a process of manufacturing a thin film photovoltaic device on a transparent substrate, with an integrated IMOD mask.

FIG. 13F is a schematic cross-sectional view of another embodiment of an IMOD mask integrated with a thin film photovoltaic device on a transparent substrate, wherein layer(s) defining a optical resonant cavity for the IMOD mask remain unpatterned.

FIG. 13G is a schematic cross-sectional view of another embodiment of an IMOD mask integrated on a front side of a transparent substrate, opposite the side of the substrate with active photovoltaic material.

FIGS. 14A and 14B are schematic cross-sectional views of a photovoltaic device formed with a single crystal semiconductor photovoltaic device, with and without an IMOD mask formed over the front electrodes.

FIG. 15 is a schematic cross-sectional view of an embodiment of an interferometrically-enhanced photovoltaic device with an integrated IMOD mask.

### DETAILED DESCRIPTION OF CERTAIN EMBODIMENTS

One issue hindering widespread adoption of photovoltaic (PV) devices on available surfaces for conversion of light energy into electric energy or current is the undesirable aesthetic appearance of front conductors or electrodes on the PV devices. The high reflectivity of common front electrode materials contrasts with the darker appearance of the active PV material itself, and furthermore hinders the blending of PV devices with surrounding materials. Embodiments described herein below employ interferometric modulator (IMOD) constructions designed to darken, hide or blend electrodes, thus providing an IMOD mask over conductors for PV devices. Light incident on the IMOD mask results in little or no visible reflection in the region of the electrodes due to the principles of optical interference. The interferometric masking effect is governed by the dimensions and fundamental optical properties of the materials making up the IMOD mask. Accordingly, the masking effect is not as susceptible to fading over time compared to common dyes or paints.

Although certain preferred embodiments and examples are discussed herein, it is understood that the inventive subject matter extends beyond the specifically disclosed embodiments to other alternative embodiments and/or uses of the invention and obvious modifications and equivalents thereof. It is intended that the scope of the inventions disclosed herein should not be limited by the particular disclosed embodiments. Thus, for example, in any method or process disclosed herein, the acts or operations making up the method/process may be performed in any suitable sequence and are not necessarily limited to any particular disclosed sequence. Various aspects and advantages of the embodiments have been described where appropriate. It is to be understood that not necessarily all such aspects or advantages may be achieved in accordance with any particular embodiment. Thus, for example, it should be recognized that the various embodiments may be carried out in a manner that achieves or optimizes one advantage or group of advantages as taught herein without necessarily achieving other aspects or advantages as may be taught or suggested herein. The following detailed description is directed to certain specific embodiments of the invention. However, the invention can be embodied in a multitude of different ways. The embodiments described herein may be implemented in a wide range of devices that include photovoltaic devices for collection of optical energy.

In this description, reference is made to the drawings wherein like parts are designated with like numerals throughout. As will be apparent from the following description, the embodiments may be implemented in a variety of devices that comprise photovoltaic active material.

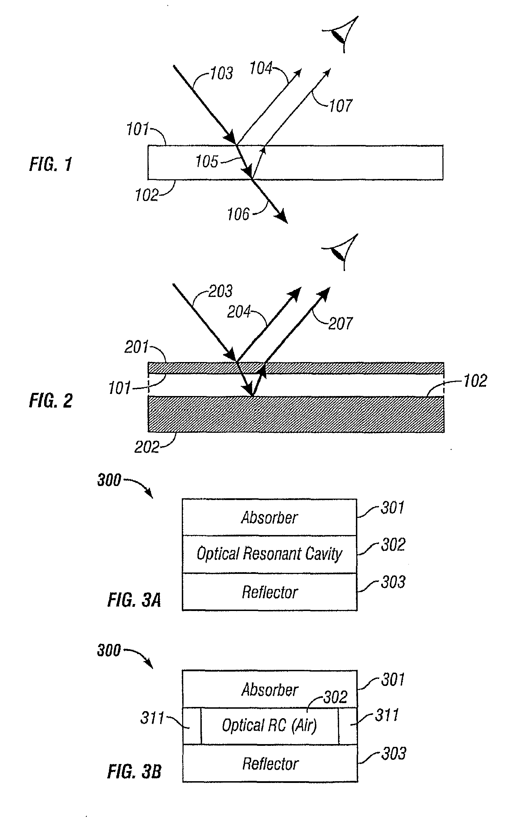

FIG. 1 illustrates an optical resonant cavity. An example of such an optical resonant cavity is a soap film which may produce a spectrum of reflected colors. The optical resonant cavity shown in FIG. 1 comprises two surfaces 101 and 102. The two surfaces 101 and 102 may be opposing surfaces on the same layer. For example, the two surfaces 101 and 102 may comprise surfaces on a glass or plastic plate or sheet or a film of glass, plastic, or any other transparent material. Air or other media may surround the plate, sheet, or film. In the illustrated example, light partially reflects and partially transmits at each of interfaces 101, 102.

A ray of light 103 that is incident on the front surface 101 of the optical resonant cavity is partially reflected as indicated by the light path 104 and partially transmitted through the front surface 101 along light path 105. The transmitted light may be partially reflected along light path 107 and partially transmitted out of the resonant cavity along light path 106. The amount of light transmitted and reflected may depend on the refractive indices of the material that forms the optical resonant cavity and of the surrounding medium. The example is simplified by omission of multiple internal reflections, as will be appreciated by the skilled artisan.

For purposes of the discussions provided herein, the total intensity of light reflected from the optical resonant cavity is a coherent superposition of the two reflected light rays 104 and 107. With such coherent superposition, both the amplitude and the phase of the two reflected beams contribute to the aggregate intensity. This coherent superposition is referred to as interference. The two reflected rays 104 and 107 may have a phase difference with respect to each other. In some embodiments, the phase difference between the two waves may be 180 degrees and cancel each other out. If the phase and the amplitude of the two light rays 104 and 107 are configured so as to reduce the intensity then the two light beams are referred to as interfering destructively. If on the other hand the phase and the amplitude of the two light beams 104 and 107 are configured so as to increase the intensity then the two light rays are referred to as interfering constructively. The phase difference depends on the optical path difference of the two paths, which depends both on the thickness of the optical resonant cavity, the index of refraction of the material between the two surface 101 and 102, and whether the indices of surrounding materials are higher or lower than the material forming the optical resonant cavity. The phase difference is also different for different wavelengths in the incident beam 103. Accordingly, in some embodiments the optical resonant cavity may reflect a specific set of wavelengths of the incident light 103 while transmitting other wavelengths of the incident light 103. Thus some wavelengths may interfere constructively and some wavelengths may interfere destructively. In general, the colors and the total intensity reflected and transmitted by the optical resonant cavity thus depend on the thickness and the material forming the optical resonant cavity and surrounding media. The reflected and transmitted wavelengths also depend on viewing angle, different wavelength being reflected and transmitted at different angles.

In FIG. 2, an optical resonant cavity is defined between two layers. In particular, an absorber layer 201 defines the top or front surface 101 of the optical resonant cavity while a bottom reflector layer 202 defines the bottom or back surface 102 of the optical resonant cavity. The thickness of the absorber and reflector layers may be substantially different from each other. For example, the absorber layer 201 will typically be thinner than the bottom reflector layer 202 and is designed to be partially transmissive. The absorber and reflector layers may comprise metal. As shown in FIG. 2, the ray of light 203 that is incident on the absorber layer 201 of the optical interference cavity is partially reflected out of the optical interference cavity along each of the paths 204 and 207. The illumination field as viewed by an observer on the front or incident side is a superposition of the two reflected rays 204 and 207. The amount of light substantially absorbed by the device or transmitted out of the device through the bottom reflector 202 can be significantly increased or reduced by varying the thickness and the composition of the reflector layers, whereas the apparent color of reflections is largely determined by the interference effect governed by the size or thickness of the optical resonant cavity 101 and the material properties of the absorber layer 201.

In some embodiments, the optical cavity between the front and back surfaces 101, 102 is defined by a layer, such as an optically transparent dielectric layer, or plurality of layers. In other embodiments, the optical resonant cavity between the front and back surfaces 101, 102 is defined by an air gap or combination of optically transparent layer(s) and an air gap. The size of the optical interference cavity may be tuned to maximize or minimize the reflection of one or more specific colors of the incident light. The color or colors reflected by the optical interference cavity may be changed by changing the thickness of the cavity. Accordingly, the color or colors reflected by the optical interference cavity may depend on the thickness of the cavity. When the cavity height is such that particular wavelength(s) are maximized or minimized by optical interference, the structure is referred to herein as an interferometric modulator (IMOD).

In certain embodiments, the optical resonant cavity height between the top absorber and the bottom reflector may be actively varied for example by microelectromechanical systems (MEMS). MEMS include micromechanical elements, actuators, and electronics. Micromechanical elements may be created using deposition, etching, and/or other micromachining processes that etch away or remove parts of substrates and/or deposited material layers or that add layers to form electrical and electromechanical devices. Such MEMS devices include IMODs having an optical resonant cavity that can be adjusted electromechanically. An IMOD selectively absorbs and/or reflects light using the principles of optical interference. In certain embodiments, an interferometric modulator may comprise a pair of conductive plates, one of which is partially reflective and partially transmissive and the other of which is partly or totally reflective. The conductive plates are capable of relative motion upon application of an appropriate electrical signal. In a particular embodiment, one plate may comprise a stationary layer deposited on a substrate and the other plate may comprise a metallic membrane separated from the stationary layer by an air gap. As described herein in more detail, the position of one plate in relation to another can change the optical interference of light incident on the interferometric modulator. In this manner, the color of light output by the interferometric modulator can be varied.

Using such a MEMS-adjustable optical interference cavity or IMOD, it is possible to provide at least two states. A first state comprises an optical interference cavity of a certain dimension whereby light of a selected color (based upon the size of the cavity) interferes constructively and is reflected out of the cavity. A second state comprises a visible black state produced due to constructive and/or destructive interference of light, such that visible wavelength are substantially absorbed. Alternatively, the two states can be colored and broad spectrum (white) reflective.

FIG. 3A is a simplified schematic of an IMOD stack 300. As illustrated, the IMOD stack 300 comprises an absorber layer 301, a reflector 303, and an optical resonant cavity 302 formed between the absorber layer 301 and the reflector 303. The reflector 303 may, for example, comprise a metal layer, such as aluminum and is typically thick enough to be opaque (e.g., 300 nm). The optical resonant cavity 302 may comprise an air gap and/or one or more optically transparent materials. If the optical resonant cavity 302 is defined by a single layer between the reflector 303 and the absorber layer 301, a transparent conductor or transparent dielectric may be used. In some embodiments, the optical resonant cavity 302 can comprise a composite structure comprising multiple materials that may include two or more of an air gap, a transparent conducting material, and a transparent dielectric layer. A possible advantage of multiple layers and/or air gaps is that selected layers of the stack may serve multiple functions, such as device passivation or scratch resistance in addition to its optical role in the IMOD stack 300. In some embodiments, the optical resonant cavity may comprise one or more partially transparent materials, whether conductive or dielectric. Exemplary transparent materials for the optical interference cavity 302 may comprise the transparent conductive oxide (TCO) indium tin oxide (ITO) and/or the dielectric silicon dioxide (SiO₂).

In this embodiment light passes through the IMOD stack 300 first by passing into the absorber layer 301. Some light passes through the partially transmissive absorber layer 301, through the optical interference cavity 302, and is reflected off the reflector 303 back through the optical resonant cavity 302 and through the absorber layer 301.

With reference to FIG. 3B, in other embodiments, the thickness of the optical resonant cavity 302 may comprise an air gap 302 supported by spacers 311, such as rails, posts or pillars. Within the IMOD 300, the optical resonant or interference cavity 302 may be an air gap that is static, or one that is dynamic, i.e., variable using, for example, MEMS technology.

An interferometric modulator (IMOD) structure such as shown in FIGS. 3A or 3B selectively produces a desired reflection output using optical interference. This reflected output may be "modulated" by selection of the thickness and optical properties of the optical resonant cavity 302, as well as the thickness and optical properties of the absorber 301 and the reflector 303. The reflected output may also be varied dynamically using a MEMS device to change the size of the optical resonant cavity 302. The color observed by a viewer viewing the surface of the absorber 301 will correspond to those frequencies that are substantially reflected out of the IMOD and are not substantially absorbed or destructively interfered by the various layers of the IMOD. The frequencies that interfere and are not substantially absorbed can be varied by selecting the thickness of the optical resonant cavity 302.

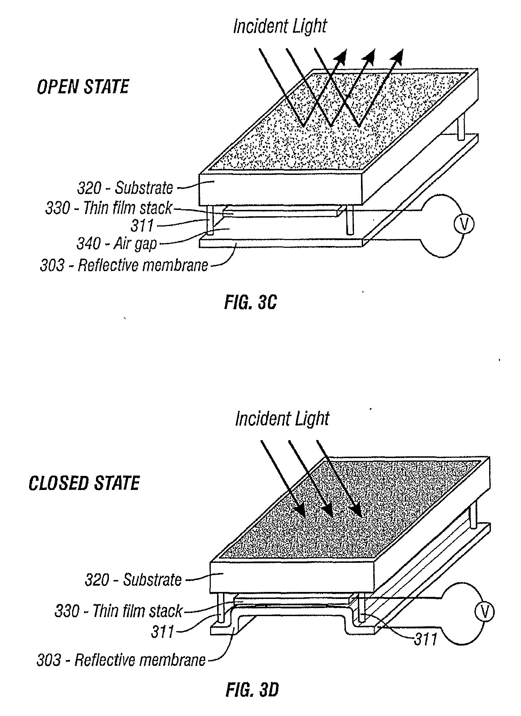

FIGS. 3C and 3D show an embodiment of an IMOD wherein the optical resonant cavity (302 in FIG. 3B) includes an air gap and can be electromechanically changed using MEMS technology. FIG. 3C illustrates an IMOD configured to be in the "open" state and FIG. 3D illustrates an IMOD configured to be in the "closed" or "collapsed" state. The IMOD illustrated in FIGS. 3C and 3D comprises a substrate 320, a thin film stack 330 and a reflective membrane 303. The thin film stack 330 may comprise an absorber (corresponding to 303 in FIGS. 3A and 3B) as well as other layers and materials, such as a separate transparent electrode and dielectric layer. In some embodiments, the thin film stack 330 may be attached to the substrate 320. In the "open" state, the thin film stack 330 is separated from the reflective membrane 303 by a gap 340. In some embodiments, for example, as illustrated in FIG. 3C, the gap 340 may be an air gap, supported by spacers 311, such as rails, pillars or posts. In the "open" state, the thickness of the gap 340 can vary, for example, between 120 nm and 400 nm (e.g., approximately 260nm) in some embodiments. Hence, in the "open" state, the optical resonant cavity of FIGS. 3A and 3B comprises the air gap together with any transparent layers over the absorber within the thin film stack 330.

In certain embodiments, the IMOD can be switched from the "open" state to the "closed" state by applying a voltage difference between the thin film stack 330 and the reflective membrane 303 as illustrated in FIG. 3D. In the "closed" state, the optical cavity over the absorber between the thin film stack 330 and the reflective membrane 303 is defined by, e.g., a dielectric layer overlying the absorber in the thin film stack 330, and is typically configured to reflect "black" or minimal visible reflections. The thickness of the air gap in general can vary between approximately 0 nm and approximately 2000 nm, for example, between "open" and "closed" states in some embodiments.

In the "open" state, one or more frequencies of the incident light interfere constructively above the surface of the substrate 320. Accordingly, some frequencies of the incident light are not substantially absorbed within the IMOD but instead are reflected from the IMOD. The frequencies that are reflected out of the IMOD interfere constructively outside the IMOD. The display color observed by a viewer viewing the surface of the substrate 320 will correspond to those frequencies that are substantially reflected out of the IMOD and are not substantially absorbed by the various layers of the IMOD. The frequencies that interfere constructively and are not substantially absorbed can be varied by changing the thickness of the optical cavity (which includes the gap 340), thereby changing the thickness of the optical resonant cavity.

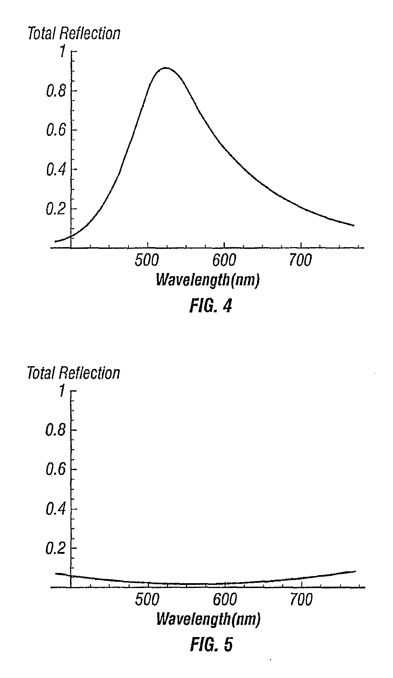

FIG. 4 illustrates a graph of total reflection of an IMOD (for example, the IMOD 300 of FIGS. 3A or 3B) versus wavelength as seen from a direction normal or perpendicular to the front surface of the IMOD. The graph of total reflection shows a reflection peak at approximately 550 nm (yellow). A viewer viewing the IMOD will observe the IMOD to be yellow. As mentioned previously, the location of the peak of the total reflection curve can be shifted by changing either the thickness or material of the optical resonant cavity 302 or by changing the material and thickness of one or more layers in the stack.

FIG. 5 illustrates a graph of total reflection of the IMOD versus wavelength over a wavelength range of approximately 400 nm to 800 nm for an IMOD with an optical cavity thickness selected to minimize reflections in the visible range. It is observed that the total reflection is uniformly low in the entire wavelength range. Thus very little light is reflected out of the interferometric modulator. The color observed by a viewer looking perpendicularly at the front surface of the IMOD may generally be black, reddish black or purple in some embodiments.

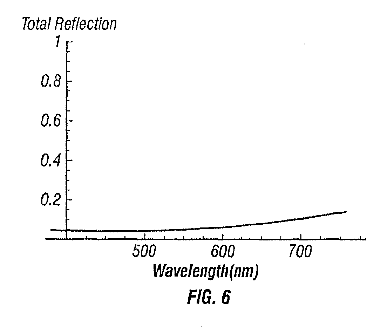

Generally, an IMOD stack can have a view angle dependency. However, when an optical resonant cavity is selected to minimize IMOD reflection in the visible range, the angle dependency tends to be fairly low. FIG. 6 illustrates total reflection versus wavelength for an IMOD with an optical resonant cavity, optimized to minimize visible reflections, when the angle of incidence or view angle is 30 degrees. It is observed that the total reflection is uniformly low in the entire visible wavelength range. Thus very little visible light is reflected out of the interferometric modulator. A comparison of FIGS. 5 and 6 shows that the spectral response of the IMOD with a cavity 302 chosen or modulated to minimize visible reflection is approximately the same for normal incidence and when the angle of incidence or view angle is 30 degrees. In other words, the spectral response of a "black" IMOD, with a cavity selected to minimize visible reflections, does not exhibit a strong dependency on the angle of incidence or the view angle.

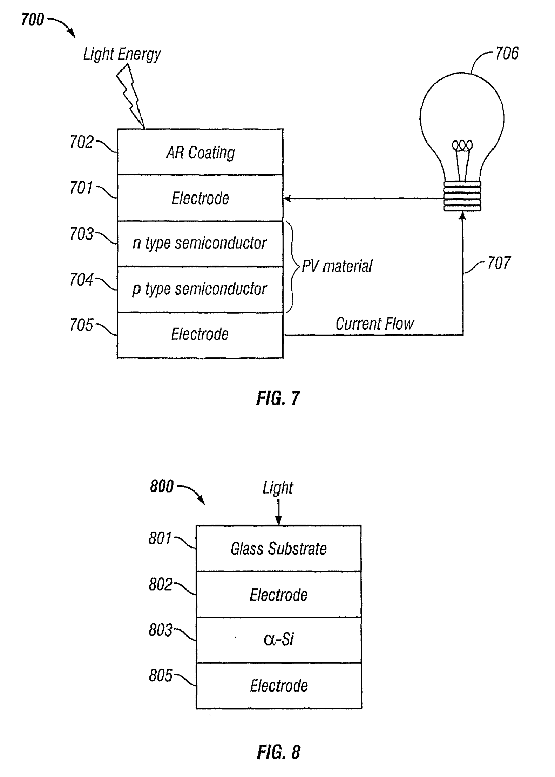

FIG. 7 shows a typical photovoltaic (PV) cell 700. A typical photovoltaic cell can convert light energy into electrical energy or current. A PV cell is an example of a renewable source of energy that has a small carbon footprint and has less impact on the environment. Using PV cells can reduce the cost of energy generation and provide possible cost benefits. PV cells can have many different sizes and shapes, e.g., from smaller than a postage stamp to several inches across. Several PV cells can often be connected together to form PV cell modules that may be up to several feet long and a few feet wide. Modules, in turn, can be combined and connected to form PV arrays of different sizes and power output.

The size of an array can depend on several factors, such as the amount of sunlight available in a particular location and the needs of the consumer. The modules of the array can include electrical connections, mounting hardware, power-conditioning equipment, and batteries that store solar energy for use when the sun is not shining. A PV device can be a single cell with its attendant electrical connections and peripherals, or a PV module or a PV array. A PV device can also include functionally unrelated electrical components, e.g., components that are powered by the PV cell(s).

A typical PV cell comprises a PV active region disposed between two electrodes. In some embodiments, the PV cell comprises a substrate on which a stack of layers is formed. The PV active layer of a PV cell may comprise a semiconductor material such as silicon. In some embodiments, the active region may comprise a p-n junction formed by contacting an n-type semiconductor material 703 and a p-type semiconductor material 704 as shown in FIG. 7. Such a p-n junction may have diode-like properties and may therefore be referred to as a photodiode structure as well.

The PV active layer(s) 703, 704 are sandwiched between two electrodes that provide an electrical current path. The back electrode 705 can be formed of aluminum, silver, or molybdenum or some other conducting material. The back electrode can be rough and unpolished. The front electrode 701 is designed to cover a significant portion of the front surface of the p-n junction so as to lower contact resistance and increase collection efficiency. In embodiments wherein the front electrode 701 is formed of an opaque material, the front electrode 701 is configured to leave openings over the front of the PV active layer to allow illumination to impinge on the PV active layer. In some embodiments, the front electrodes can include a transparent conductor, for example, transparent conducting oxide (TCO) such as tin oxide (SnO₂) or indium tin oxide (ITO). The TCO can provide good electrical contact and conductivity and simultaneously be transparent to the incoming light. In some embodiments, the PV cell can also comprise a layer of anti-reflective (AR) coating 702 disposed over the front electrode 701. The layer of AR coating 702 can reduce the amount of light reflected from the front surface of the PV active layer(s) 703, 704.

When the front surface of the active PV material is illuminated, photons transfer energy to electrons in the active region. If the energy transferred by the photons is greater than the band-gap of the semiconducting material, the electrons may have sufficient energy to enter the conduction band. An internal electric field is created with the formation of the p-n junction. The internal electric field operates on the energized electrons to cause these electrons to move thereby producing a current flow in an external circuit 707. The resulting current flow can be used to power various electrical devices, such as a light bulb 706 as shown in FIG. 7.

In some embodiments, the p-n junction shown in FIG. 7 can be replaced by a p-i-n junction wherein an intrinsic or un-doped semiconducting layer is sandwiched between a p-type and an n-type semiconductor. A p-i-n junction may have higher efficiency than a p-n junction. In some other embodiments, the PV cell can comprise multiple junctions.

The PV active layer(s) can be formed by any of a variety of light absorbing, photovoltaic materials such as crystalline silicon (c-silicon), amorphous silicon (α-silicon), cadmium telluride (CdTe), copper indium diselenide (CIS), copper indium gallium diselenide (CIGS), light absorbing dyes and polymers, polymers dispersed with light absorbing nanoparticles, III-V semiconductors such as GaAs, etc. Other materials may also be used. The light absorbing material(s) where photons are absorbed and transfer energy to electrical carriers (holes and electrons) is referred to herein as the PV active layer of the PV cell, and this term is meant to encompass multiple active sub-layers. The material for the PV active layer can be chosen depending on the desired performance and the application of the PV cell.

In some embodiments, the PV cell can be formed by using thin film technology. For example, in one embodiment, where optical energy passes through a transparent substrate, the PV cell may be formed by depositing a first or front electrode layer of TCO on a substrate. PV active material is deposited on the first electrode layer. A second electrode layer can be deposited on the layer of PV active material. The layers may be deposited using deposition techniques such as physical vapor deposition techniques, chemical vapor deposition techniques, electro-chemical vapor deposition techniques, etc. Thin film PV cells may comprise amorphous or polycrystalline materials such as thin-film silicon, CIS, CdTe or CIGS. Some advantages of thin film PV cells are small device footprint and scalability of the manufacturing process among others.

FIG. 8 is a block diagram schematically illustrating a typical thin film PV cell 800. The typical PV cell 800 includes a glass substrate 801 through which light can pass. Disposed on the glass substrate 801 are a first electrode layer 802, a PV active layer 803 (shown as comprising amorphous silicon), and a second electrode layer 805. The first electrode layers 802 can comprise a transparent conducting material such as ITO. As illustrated, the first electrode layer 802 and the second electrode layer 805 sandwich the thin film PV active layer 803 therebetween. The illustrated PV active layer 803 comprises an amorphous silicon layer. As is known in the art, amorphous silicon serving as a PV material may comprise one or more diode junctions. Furthermore, an amorphous silicon PV layer or layers may comprise a p-i-n junction wherein a layer of intrinsic silicon is sandwiched between a p-doped layer and an n-doped layer.

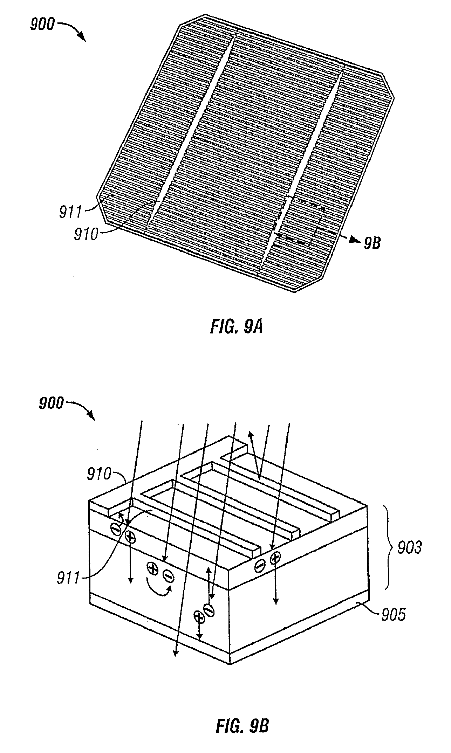

As illustrated in FIGS. 9A and 9B, many PV devices employ specular or reflective conductors 910, 911 on a front, or light-incident, side of the device as well as on a back side of the PV device 900. Conductors on the front or light-incident side can comprise bus electrodes 910 or gridline electrodes 911. When optical energy is absorbed by the PV active material 903, electron-hole pairs are generated. These electrons and holes can generate current by moving to one or the other of the front electrodes 910, 911 or back electrodes 905, as shown in FIG. 9B. The front conductors or electrodes 910, 911 are patterned to both reduce the distance an electron or hole must travel to reach an electrode while also allowing enough light to pass through to the PV active layer 903. However, the lines of bright reflections generated by these electrodes are often considered to be unattractive, such that PV devices are often not employed in visible locations.

Accordingly, some embodiments below describe methods of covering unsightly electrodes so that the electrode pattern appears dark or black to better match the appearance of exposed PV active regions. Furthermore, some embodiments described below provide photovoltaic devices that are uniform in appearance so that they can better blend in with surrounding structures (e.g., rooftop tiles). This may be achieved either by darkening the portion of the front of the PV device that has patterned electrodes, or by rendering the entire front surface of the photovoltaic device dark.

One way of darkening or otherwise masking the electrode so as to suppress reflections from a conducting layer or electrode is to use an interferometric modulator (IMOD) as a mask, with reflectance tuned to darken the electrodes and/or blend with the color appearance of exposed PV active regions. In the IMOD stack, the function of the IMOD reflector (e.g., reflector 303 of FIGS. 3A or 3B) can be served by the conductor being masked (e.g., front bus electrodes 910 or grid line electrodes 911 of FIGS. 9A and 9B). Light incident on the IMOD mask results in little or no visible reflection in the region of the electrodes due to the principles of optical interference discussed above. Advantageously, the interferometric effect is governed by the thickness and material(s) of the absorber and optical resonant cavity. Accordingly, the masking effect is not as susceptible to fading over time compared to common dyes or paints.

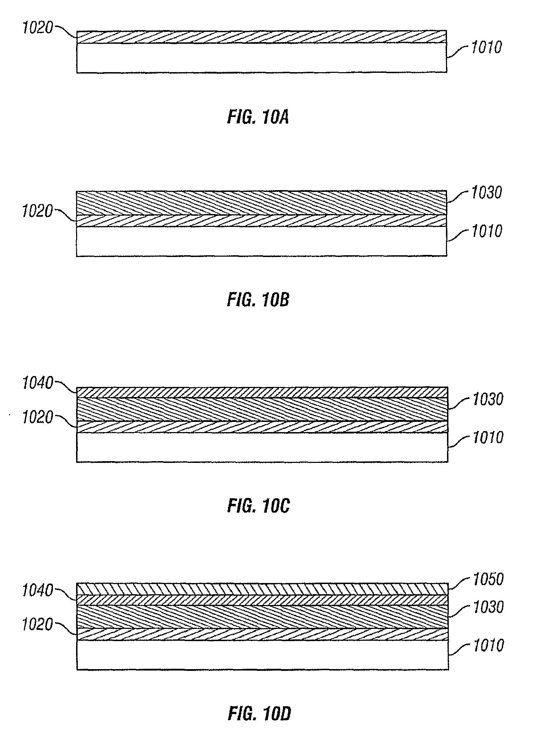

FIGS. 10A-10G illustrate one example of a process for fabricating a PV device incorporating an IMOD mask on front electrodes. The example employs a deposited thin film of PV active material. In one embodiment, such a photovoltaic device may be formed on a substrate 1010 such as plastic, glass or other suitable workpiece. As illustrated in FIG. 10A, a method of manufacturing such a device can comprise forming a back electrode 1020 on a substrate 1010 using known methods. A metal layer may be deposited to serve as the back electrode 1020 for a photovoltaic device, but non-metal conducting materials can also be used.

With reference to FIG. 10B, the method further includes formation of a photovoltaic active material 1030. In the illustrated embodiment, the photovoltaic (PV) active material 1030 comprises a deposited thin film, although in other arrangements portions of single crystal, semiconductor substrates and/or epitaxial layers thereover are employed. A deposited PV active material can comprise, for example, an amorphous silicon thin film, which has recently been gaining in popularity. Amorphous silicon as thin films can be deposited over large areas by physical vapor deposition (PVD), chemical vapor deposition (CVD), electro-chemical vapor deposition, or plasma-enhanced chemical vapor deposition (PECVD) as well as other methods known to those of skill in the art. As is known by those with skill in the art, PV active materials comprising amorphous silicon layers may include one or more junctions with n-doped and/or p-doped silicon and may further comprise p-i-n junctions. Other appropriate materials for the PV active material 1030 include germanium (Ge), Ge alloys, and alloys like copper indium gallium selenide (CIGS), cadmium telluride (CdTe), as well as III-V semiconductor materials, or tandem multi-junction photovoltaic materials and films. III-V semiconductor materials include such materials as gallium arsenide (GaAs), indium nitride (InN), gallium nitride (GaN), boron arsenide (BAs). Semiconductor alloys like indium gallium nitride may also be used. Other photovoltaic materials and devices are also possible. Methods of forming these materials are known to those having skill in the art. As an illustrative example, alloys like CIGS can be formed by a vacuum-based process where copper, gallium, and indium are co-evaporated or co-sputtered then annealed with a selenide vapor to form the final CIGS structure. Non-vacuum-based alternative processes are also known to those of skill in the art.

In FIG. 10C, a transparent conducting oxide (TCO) 1040 is optionally deposited over the PV active material 1030. TCO layers are often used with photovoltaic materials, particularly thin film photovoltaic materials, in order to improve electrode contact to the PV active layer 1030. Functionally the TCO 1040 forms a part of the front electrodes completing a circuit for carrying current generated by the PV active material 1030, but conventionally the more conductive metal conductors that overlie the TCO 1040 and connect the PV cell to a wider circuit are referred to as the front electrodes. As known to those with skill in the art, a common TCO is indium tin oxide (ITO). Methods of forming or depositing ITO are well known in the art and include electron beam evaporation, physical vapor deposition, or sputter deposition techniques. Other TCO materials and processes of manufacture may also be used. The TCO layer can be omitted in other embodiments.

In FIG. 10D, deposition of the TCO material 1040 is followed by the forming of a front conductor layer 1050. The front conductor layer 1050 may comprise a metal or highly conductive material to serve as a front electrode and connect the PV cell into a circuit that carries current generated by the PV cell. As noted above, such conductors tend to be fairly reflective and can spoil the appearance of the PV device and hinder widespread use of PV devices. Typical reflective materials for the front conductor layer 1050 include aluminum (Al), molybdenum (Mo), zirconium (Zr), tungsten (W), iron (Fe), silver (Ag), and chromium (Cr).

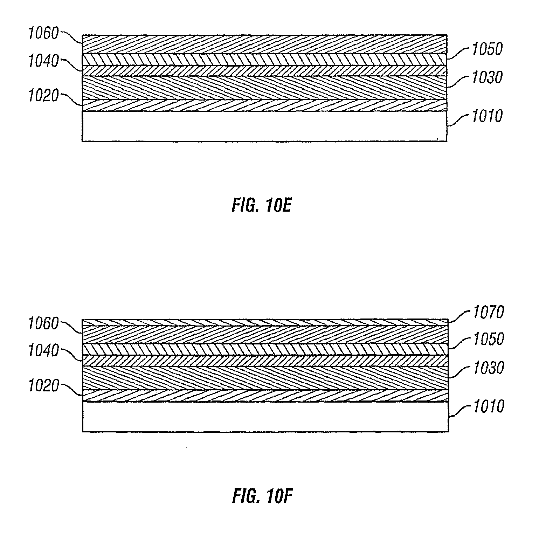

As shown in FIG. 10E, an optical resonant cavity 1060 is formed over the front conductor 1050. In the illustrated embodiment, the optical resonant cavity 1060 is a deposited transparent layer, although, as discussed above with respect to FIGS. 3A and 3B, in other arrangements the cavity can comprise an air gap (see FIG. 3B) defined by spacers, such as posts, pillars or rails; a single transparent conductive or dielectric layer; a composite formed by multiple conductive or dielectric transparent layers; or a composite formed by combination of an air gap with one or more transparent layers. Optical resonant cavities of a single layer of transparent material can simplify manufacturing and reduce costs. Composite structures with multiple layers and/or air gaps can employ multiple layers to serve multiple functions, such as device passivation or scratch resistance in addition to its optical role in the IMOD mask being formed.

Air gaps or composite optical resonant cavities can also serve multiple functions, such as device ventilation or providing the ability to employ MEMS for either reflecting multiple colors (e.g., a color mode and a black mask mode) or for forming an actively tunable IMOD mask. In the illustrated embodiments where the reflector 303 of the IMOD mask also serves as a front electrode for a PV device, the reflector 303 can be used as a stationary electrode for electrostatic actuation, for example, when the PV device is not active. The absorber 301 can act as a movable electrode. The skilled artisan will appreciate that interconnection and external circuits for handling dual functions of electrostatic MEMS operation and current collection from a PV device can be integrated with the active IMOD mask of the PV device.

The optical resonant cavity 1060 of one embodiment is formed by a layer of SiO₂ or other transparent dielectric material. A suitable thickness for an SiO₂ (or similar index) optical resonant cavity 1060 is between 300 Å (angstrom) and 1000 Å to produce an interferometric dark or black effect. Methods of depositing or forming SiO₂ are known in the art, including CVD as well as other methods. Other suitable transparent materials for forming the optical resonant cavity 1060 include ITO, Si₃N₄, and Cr₂O₃. The optical resonant cavity 1060 of another embodiment is formed by an air gap layer of SiO₂ or other transparent dielectric material. A suitable thickness for an air gap optical resonant cavity 1060 is between 450 Å and 1600 Å to produce an interferometric dark or black effect.

Referring to FIG. 10F, an absorber layer 1070 is formed over the optical resonant cavity 1060. In the illustrated embodiment, where the IMOD mask being constructed is designed to interferometrically darken the appearance of the naturally reflective front conductor 1050, the absorber layer 1070 may comprise, for example, semitransparent thicknesses of metallic or semiconductor layers. The absorber layer may also comprise materials that have a non-zero n*k, i.e., a non-zero product of the index of refraction (n) and extinction coefficient (k). In particular, chromium (Cr), molybdenum (Mo), titanium (Ti), silicon (Si), tantalum (Ta) and tungsten (W) all form suitable layers. In one embodiment the thickness of the absorber layer 1070 is between 20 Å and 300 Å.

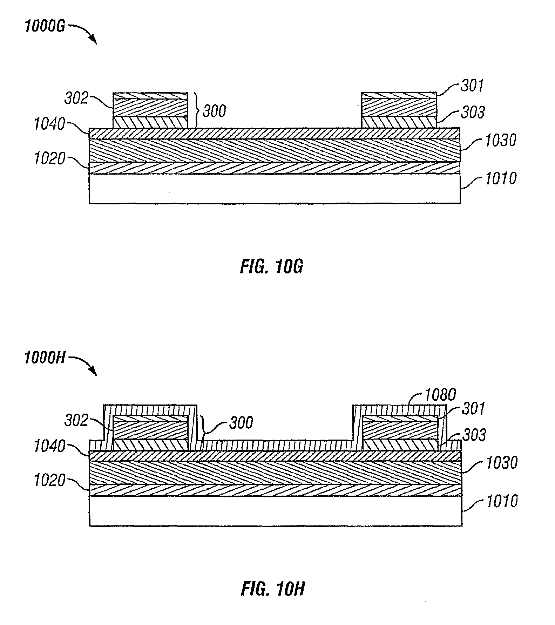

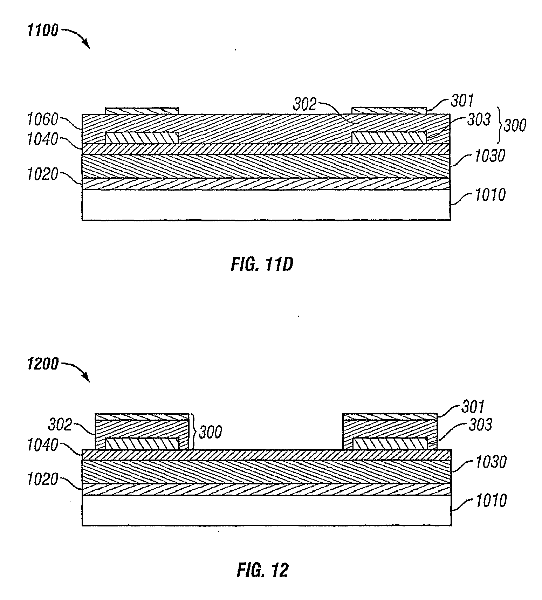

With reference to FIG. 10G, the stack illustrated in FIG. 10F is then patterned using, e.g., photolithographic patterning and etching or other suitable technique to form a PV device 1000G as shown in FIG. 10G. The resultant interferometric modulator (IMOD) mask 300 comprises a reflector 303 (also serving as a front conductor or electrode for the PV device), an optical resonant cavity 302 (referred to by reference number 1060 prior to patterning), and a patterned absorber 301. In the embodiment of FIG. 10G, the reflector 303, optical resonant cavity 302, and the absorber 301 are patterned together and hence aligned with one another. In other arrangements, components of the IMOD mask 300 may have a pattern that differs in some fashion from the pattern of the conductor that serves as the IMOD mask reflector 303, as will be better understood from the discussion of FIG. 12 below. The IMOD mask 300 thus covers the front electrode or reflector 303. Alignment of the IMOD mask 300 with the reflectors 303 that serve as front electrodes for the PV device risks some minimal reflections from the sides of the reflectors 303 at acute viewing angles. However, the absorber 301 is patterned in a fashion that does not prevent any more light from reaching the PV active layer than the reflector 303, which is present anyway as a front electrode, already does. Thus, the absorber 301 is patterned in a manner that avoids any further reduction in PV efficiency.

The materials and dimensions of the absorber 301 and the optical resonant cavity 302 are selected to reduce reflectivity from the underlying reflector 303. Reflectivity is defined as a ratio of [the intensity of light reflected from the IMOD mask 300] to [the intensity of incident light upon the top of the IMOD mask 300] in the direction normal to the upper surface of the mask 300. Common PV device front electrode materials for the reflector 303 exhibit reflectivity in the range of 30%-90%. The IMOD mask 300, however, is configured to interferometrically reduce the overall reflectivity to less than 10%. Thus, the reflectivity observable above the IMOD mask 300 is for most common reflector 303 materials less than 10% (at which point the reflections tend to appear "gray"), and more typically less than 5%. The skilled artisan will appreciate, in view of the disclosure herein, that reflectivity can be reduced to as little as 1%-3%, thus truly appearing "black," by proper selection of the materials and dimensions for the layer(s) in the absorber 301 and the optical resonant cavity 302.

Thus, little or no light is seen reflecting from the front conductor of the PV device by an observer. Hence the pattern formed by the IMOD mask 300 covering the electrode may appear dark or black. Alternatively, the structure of the IMOD mask 300 is selected to reflect a color substantially matching the color of visible regions of the photovoltaic active material adjacent the front conductor. For most PV devices the PV active area appears quite dark, such that reducing visible reflection by way of the IMOD mask 300 effectively blends the conductors in with appearance of the PV active area, making it difficult to distinguish the two regions of the PV device by sight. However, to the extent the visible regions of PV active material demonstrates color(s) other than dark or black, either due to unconventional PV materials or other coatings over the windows to the PV active material, the IMOD mask 300 may be constructed to reflect other colors in order to match with the visible regions of the PV active area and produce a uniform color or appearance for the PV device.

In one example, where the optical resonant cavity 302 comprises an air gap defined by spacers, such as posts, pillars or rails (see FIG. 3B), a suitable height of the air gap for producing a dark or black IMOD mask 300 is between 450 Å and 1600 Å, depending in part on the other materials selected for the IMOD mask 300. In another example, where the optical resonant cavity 302 comprises a dielectric with an index of refraction between 1 and 3 (e.g., SiO₂), a dark or black IMOD mask 300 can be produced with a dielectric thickness between 300 Å and 1000 Å.

With reference to FIG. 10H, the PV device 1000H can comprise additional layers, such as overlying hard coats, anti-reflection coatings or passivation layers, without detracting from the masking function of the IMOD mask. For example, a dielectric layer 1080 overlying the IMOD mask 300 can comprise SiO₂ or silicon nitride and can serve as a top passivation layer for the PV device. Furthermore, the dielectric layer 1080 can be provided in a thickness suitable to serve as an antireflective (AR) layer which can further enhance the black state of the front electrode regions. Typical thicknesses for AR layers of silicon oxide or nitride are between about 300 Å and 1500 Å. To the extent other layers are positioned between the viewer and the front electrode reflector 303, adjustments may be called for in the choice of materials, optical properties, and thicknesses of the various layers to ensure that the interferometric mask 300 produces the desired reflectivity.

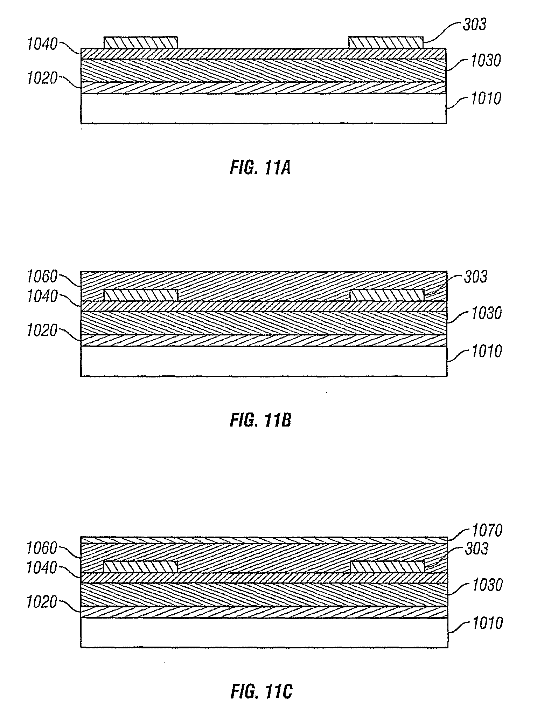

FIGS. 11A-11D illustrate another embodiment in which an IMOD black mask is formed after patterning the front electrodes. FIG. 11A illustrates the PV device structure of FIG. 10D after the conductor layer 1050 of FIG. 10D has been patterned, such as by photolithography and etching. Suitable materials for the front conductor layer 1050 are discussed above with respect to FIG. 10D. Patterning defines patterned conductors or front electrodes, which will also serve as the reflector 303 for the IMOD mask to be formed. The structure may represent, for example, a prefabricated photovoltaic (PV) device prior to packaging. Alternatively, in another embodiment, the PV device may be packaged and include, for example, a passivation layer (not shown) over the structure of FIG. 11A prior to conducting the steps of FIGS. 11B-11D. In such an arrangement the selection of materials and dimensions for the subsequently formed optical resonant cavity and absorber should account for the optical effect of the passivation layer. Put another way, the passivation layer (not shown) can be considered a part of a composite optical resonant cavity being formed.

FIG. 11B shows the structure of FIG. 11A after forming a blanket layer or composite structure selected to define the optical resonant cavity layer 1060 for the IMOD mask. As noted in the discussion of FIG. 10E, the optical resonant cavity layer 1060 can be an air gap (see FIG. 3B) defined by spacers, such as posts, pillars or rails; a single transparent conductive or dielectric layer; a composite formed by multiple conductive or dielectric transparent layers; or a composite formed by combination of an air gap with one or more transparent layers.

FIG. 11C illustrates the structure of FIG. 11B after deposition of an absorber layer 1070. Suitable materials and thicknesses for the semitransparent absorber layer 1070 are discussed above with respect to FIG. 10F.

FIG. 11D illustrates the structure of FIG. 11C after patterning the absorber layer 1070 to leave a patterned absorber 301. In the illustrated embodiment, the optical resonant cavity layer 1060 is left as a blanket or unpatterned layer. Hence the optical resonant cavity layer 1060 is blanketed over the PV cell. The absorber 301 is patterned, such as by photolithographic masking and etching, to substantially cover the conductor/electrode 303.

The resultant structure of FIG. 11D is a PV device 1100 that comprises the interferometric or IMOD mask 300, including the patterned reflector 303 that also serves as a front conductor or front electrode for the PV device, a blanket optical resonant cavity layer 1060, and a patterned absorber 301. The blanket optical resonant cavity layer 1060, which can represent a single layer or a composite structure as discussed above, can also serve other functions across the regions where PV active layer 1030 is visible or exposed, such as passivation or antireflection for the PV active layer 1030 or optional intervening TCO layer 1040. The regions of the optical resonant cavity layer 1060 that lie between patterned reflector 303 and absorber 301 form the optical resonant cavity 302 for the IMOD mask 300. In the illustrated embodiment, the absorber 301 is patterned to be substantially aligned with the reflector 303.

FIG. 12 shows another embodiment of the invention, in which the optical resonant cavity layer 1060 and the absorber layer 1070, overlying the layers of a PV device as discussed with respect to FIG. 11C, are patterned together to cover the reflectors 303 yielding a PV device 1200 as shown in FIG. 12. In this embodiment, the absorber 301 and the optical resonant cavity 302 are both patterned so as to cover the electrode, by extending slightly beyond the electrode 303. In such an embodiment, the patterned absorber 301 could extend laterally beyond the edge of the electrode by less than 10% of the width of the electrode on each side, and in one embodiment by less than 5% of the electrode width. The wider absorber 301 better ensures covering to mask reflections from the front conductor/reflector 303, and accommodates reasonable levels of mask misalignment between the reflector 303 pattern and the absorber 301 pattern. On the other hand, by minimizing the extent that the absorber 301 is wider than the reflector 303 that is being interferometrically masked, the amount of light reaching the PV active layer 1030, and thus overall PV device efficiency, can remain high.

In other embodiments not illustrated, the absorber layer and optical resonant cavity structure can extend over all of the PV device, but in that case the absorber layer should be very thin (mostly transmissive) in order to minimize the reduction of light reaching the PV active layer. Thus, the extent of the dark or "black" effect is somewhat sacrificed when thinning a blanket absorber layer to maximize transmission. In that case it may also be desirable to employ an additional semitransparent reflector, with relatively high transmission, over the PV active layer in order to better match the reflected color with that of the IMOD in the front electrode regions.

As discussed with respect to FIG. 10H, the interferometric masks 300 of FIGS. 11D and 12 can also be protected or passivated by further layer(s) formed or deposited over the surface of the embodiments.

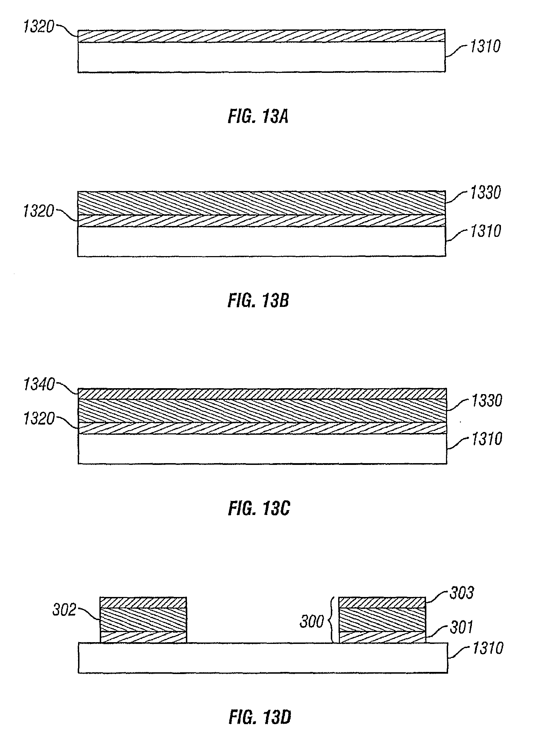

FIGS. 13A-13E depict a process for manufacturing another embodiment of the present invention, wherein layers of the PV device are formed over a transparent substrate through which light is transmitted into the PV active region. FIG. 13A begins with an appropriate optically transparent substrate 1310, such as glass, plastic, or other appropriate substrate with useful optical properties. An absorber layer 1320 is formed or deposited on the back side of the substrate, opposite the light-incident or front side. Hence, in FIGS. 13A-13E, light is incident from below. Suitable materials and thicknesses for the semitransparent absorber layer 1320 are discussed above with respect to the absorber layer 1070 of FIG. 10F.

FIG. 13B illustrates the structure of FIG. 13A after forming or depositing an optical resonant cavity layer 1330 over the absorber layer 1320. As noted in the discussion of FIG. 10E, the optical resonant cavity layer 1330 can be an air gap (see FIG. 3B) defined by spacers, such as posts, pillars or rails; a single transparent conductive or dielectric layer; a composite formed by multiple conductive or dielectric transparent layers; or a composite formed by combination of an air gap with one or more transparent layers.

FIG. 13C illustrates further formation or deposition of a conductor layer 1340 over the optical resonant cavity layer 1330. Suitable materials for the conductor layer 1340 are discussed above with respect to the conductor layer 1050 of FIG. 10D.

With reference to FIG. 13D, patterning or etching the layers 1320, 1330, 1340 forms an IMOD mask 300 pattern that is substantially similar to or covers the reflector 303 pattern. Patterning the layer stack defines patterned conductors or front electrodes, which will also serve as the reflector 303 for the IMOD mask 300. Although formed on the back side of the substrate, the reflector 303 is still frontward (closer to the light incident side) relative to the PV active layer, which has yet to be formed, and so the reflector 303 is said to define "front conductors" for the PV device.

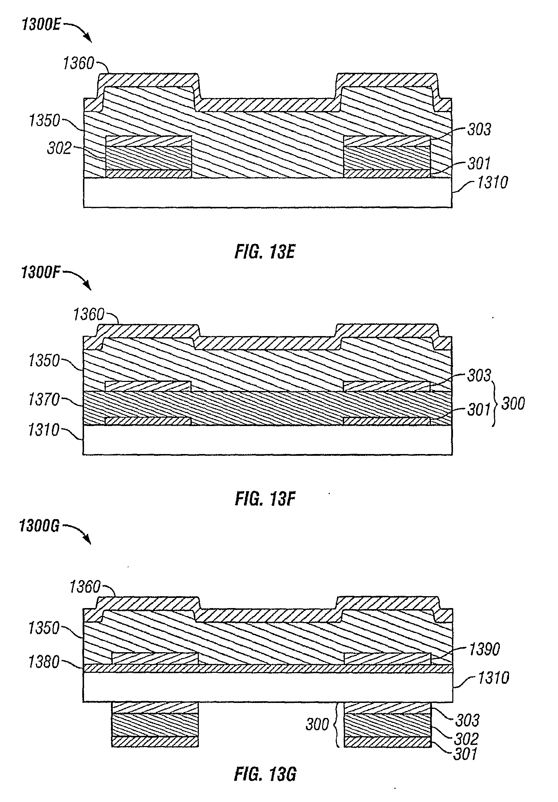

FIG. 13E illustrates the result of depositing a thin film photovoltaic (PV) active layer 1350 behind or opposite a light-incident side of the interferometric mask 300, followed by deposition of a back conductor layer 1360. Suitable materials for thin film PV active layers are discussed above with respect to FIG.10B, and in general PV active materials include numerous types of photosensitive semiconducting material, such as amorphous silicon. While not shown, a transparent conductor layer (TCO) such as ITO can be deposited prior to depositing the PV active layer 1350 in order to improve electrical contact with the front conductors 303 and thus collection efficiency of the PV device 1300E. The back conductor layer 1360 may comprise a metal conducting layer, and is typically formed to an opaque thickness.

In the embodiment of FIGS. 13A-13E, the interferometric mask 300 for a PV device is formed on the optical substrate prior to forming or depositing the PV active material 1350. In this embodiment, the photovoltaic device and the interferometric mask 300 are formed on a side of the optical substrate that is opposite the light-incident or front side of the substrate. Accordingly the sequence of layer formation can be opposite that of FIGS. 10A-10G. Additional layers (not shown) can include TCO between the PV active layer 1350 and the substrate 1310, and AR coatings or hard coats on the front side of the substrate 1310.

FIG. 13F illustrates another embodiment of the invention. FIG. 13F shows the absorber layer 1320 of FIG. 13A being patterned prior to the formation of the optical resonant cavity layer 1370, leaving a patterned absorber 301. Then optical resonant cavity layer 1370 is deposited or formed over the patterned absorber 303. As noted in the discussion of FIG. 10E, the optical resonant cavity layer 1370 can be an air gap (see FIG. 3B) defined by spacers, such as posts, pillars or rails; a single transparent conductive or dielectric layer; a composite formed by multiple conductive or dielectric transparent layers; or a composite formed by combination of an air gap with one or more transparent layers. A layer of conductor material is deposited over the optical resonant cavity layer 1370. The conductor layer may then be patterned to form the front electrode for the PV device 1300F, also serving as the patterned reflector 303 for the IMOD mask 300, while leaving the optical resonant cavity layer 1370 unpatterned over the PV cell. Subsequently the PV active layer 1350 is formed over the IMOD mask 300 (including the front electrodes) and the back electrode 1360 is formed over the PV active layer 1350.

Use of a blanket optical resonant cavity layer 1370 in an embodiment where light is transmitted through the substrate, as shown in FIG. 13F, can have several advantages. As mentioned above, a transparent conductive oxide (TCO) is often used to improve contact between an electrode and a photovoltaic material. In the embodiment of FIG. 13F, the optical resonant cavity structure can include or be formed by a TCO layer in contact with the front electrodes formed by the reflector 303.

FIG. 13G illustrates another embodiment in which the interferometric mask 300 is formed on the light-incident or front side of the transparent substrate 1310, while the front electrodes 1390 and the photovoltaic (PV) active layer 1350 are on the back side of the substrate 1310, opposite the light-incident or front side. In such an embodiment, due to the thickness of the substrate 1310 between the reflective front electrode 1390 and the absorber 301, it is desirable for the front side IMOD mask 300 to include a separate reflector 303 on the front side of the substrate 1310, patterned to cover the reflective front electrode 1390 that is on the other side of the substrate 1310. In this case, the PV device 1300G can have a conventional construction on the back side of the substrate 1310, including patterned front electrodes 1390, TCO layer 1380, PV active layer 1350 and back electrode 1360 formed in sequence over the back surface of the transparent substrate 1310. The front side of the substrate 1310 includes an IMOD mask 300 stack of a separate reflector 303, optical resonant cavity 302 and absorber 301, in sequence, formed on the front side of the light-transmissive substrate 1310. As with the illustrated embodiments, this IMOD stack would preferably be patterned to cover the front conductor 1390 pattern. Because it has its own reflector 303 and absorber 301, such an IMOD mask is electrically separated from the PV active layer 1350 and can accordingly be separately interconnected to form an electrostatic MEMS IMOD. In such an embodiment, the IMOD mask 300 would be capable of opening and closing, as illustrated in FIGS. 3C and 3D. In this case the optical resonant cavity 302 may include an air gap (340 in FIG. 3C) through which the movable electrode (303 in FIGS. 3C and 3D) can move. As will be appreciated by the skilled artisan, in such an embodiment, dielectric layers and other layers, as well as support posts for spacing the movable electrode/reflector from the stationary electrode/absorber, may be formed in front of substrate 1310 to implement a movable IMOD mask 300 on the light-incident side of substrate 1310.

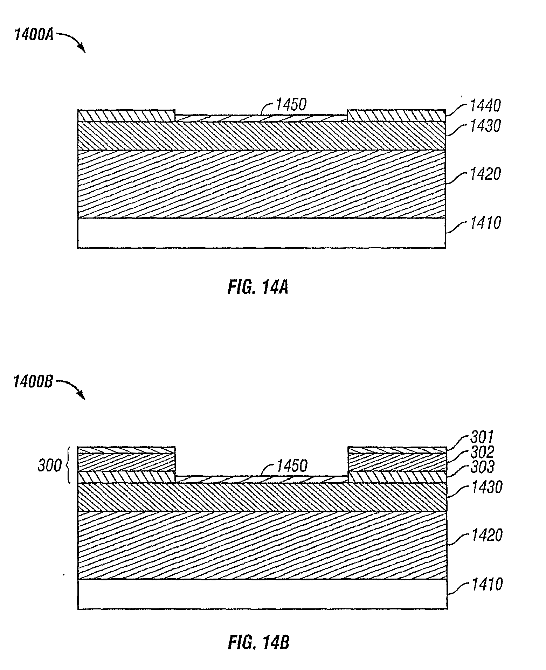

FIGS. 14A-14B illustrate an embodiment of integrating an IMOD mask with a PV device 1400A in which photovoltaic material is a portion of a single crystal semiconductor substrate and/or epitaxial layer(s) formed over such a single crystal substrate. FIG. 14A depicts a photovoltaic (PV) device 1400B comprising a back electrode 1410, a p-type silicon layer 1420, an n-type silicon layer 1430, front conductors or electrodes 1440, and an anti-reflective coating 1450. As mentioned previously, it is desirable that the front electrodes 1440 (which can be, e.g., bus lines or grid lines for a PV array) be masked, or that reflections from them be reduced or minimized. Hence, an interferometric mask 300 may be formed on a light-incident or front side of the electrodes as shown in FIG. 14B. This can be accomplished in ways similar to those described above, using similar materials. In one embodiment, the process may begin with a silicon substrate or a single crystal silicon material comprising an active region with conductors 303 already patterned, as in FIG. 14B, and the IMOD mask 300 is formed thereover. In another embodiment, the process may begin with a silicon substrate or single crystal silicon material comprising an active region without a front conductor or electrode pattern, and the front conductors are formed as reflectors 303 along with the optical resonant cavity 302 and absorber 301 using techniques similar to those discussed above with respect to FIGS. 10A-10G and 11A-11D. As noted previously, the absorber 301 and the optical resonant cavity 302, or the absorber alone, may be patterned to be substantially aligned with the front electrode/reflector 303 so as to cover the reflector 303 as shown in FIG. 14B. In another embodiment, the absorber 301 and the optical resonant cavity 302, or the absorber alone, may be patterned so as to follow the pattern of the front electrodes/reflectors 303 but be wider to cover a greater surface area than the reflector 303. As in FIGS. 11D and 13F, the optical resonant cavity layer may be left unpatterned or blanketed over the PV cell, while the front electrode/reflector 303 and absorber 301 are patterned. In yet another embodiment, the absorber 301, the optical resonant cavity 302, and/or the front electrode/reflector 303 can be screen printed, in which case formation and patterning can be conducted simultaneously. The layers that form the front electrode/reflector, optical resonant cavity and absorber can be screen printed together in any grouping or separately. Furthermore some layer(s) can be patterned by lithography and etch, while other layer(s) can be screen printed.

The foregoing embodiments teach IMOD mask constructions that can be employed to interferometrically mask front electrodes of PV devices have a wide variety of constructions. For example, in addition to the thin film and crystalline silicon PV cells and the transmissive substrate embodiments discussed above, an interferometric or IMOD mask may be used to mask reflections from the front electrodes of a thin film interferometrically enhanced photovoltaic cell or device.

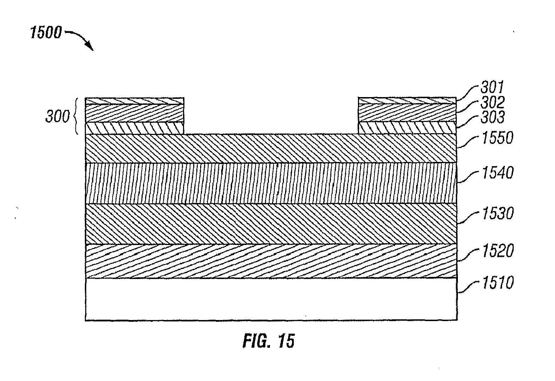

FIG. 15 illustrates an embodiment of a PV device 1500 where an interferometric mask 300 masks reflections from a reflector 303 which may serve as a front conductor or electrode of an interferometrically enhanced cell formed on a suitable substrate 1510. In the illustrated embodiment, the conductor 303 is in electrical contact with the active layer 1540 through a TCO layer 1550. In other embodiments, the conductor 303 is directly in electrical contact with the active layer 1540, or is in electrical contact through other layers and materials not shown. Certain embodiments of the interferometrically tuned photovoltaic cells comprise a reflector 1520 and an optical resonant cavity 1530 disposed behind, or opposite a light-incident side, of the PV active layer 1540. The PV active layer may comprise a thin film photovoltaic material, such as amorphous silicon, CIGS or other thin semiconductor film photovoltaic material. The optical properties (dimensions and material properties) of the reflector 1520 and optical resonant cavity 1530 are selected so that reflection from interfaces of the layered PV device 1500 coherently sum to produce an increased field in the PV active layer 1540 of the photovoltaic cell where optical energy is converted into electrical energy. Such interferometrically enhanced photovoltaic devices increase the absorption of optical energy in the active region of the interferometric photovoltaic cell and thereby increase the efficiency of the device. In variations on this embodiment, multiple optical resonant cavities can be employed to separately tune different wavelengths of light and maximize absorption in the PV active layer(s). The buried optical resonant cavities and/or layers may comprise transparent conductive or dielectric materials, air gaps, or combinations thereof.

While the foregoing detailed description discloses several embodiments of the present invention, it should be understood that this disclosure is illustrative only and is not limiting of the present invention. It should be appreciated that the specific configurations and operations disclosed can differ from those described above, and that the methods described herein can be used in contexts other than fabrication of semiconductor devices.

## Claims

1. A photovoltaic device comprising:
means for generating an electrical current from light incident on a light incident side of the generating means;
means for conducting the generated electrical current; and
means for interferometrically masking the conducting means on the light incident side of the photovoltaic device.

2. The device of Claim 1, wherein:
the means for generating the electrical current comprises a semiconductor photovoltaic active material; or
the means for conducting comprises a reflective, patterned front electrode in electrical contact with the means for generating electrical current; or
the means for interferometrically masking comprises a stack, the stack including an optical resonant cavity and an absorber over the conducting means, configured to interferometrically reduce reflectivity from the conducting means.

3. The photovoltaic device of Claim 1, wherein:
the means for generating the electrical current comprises a photovoltaic active layer;
the means for conducting comprises a conductor on the light incident side of the photovoltaic active layer; and
the means for interferometrically masking comprises an interferometric mask patterned to cover the light incident side of the conductor.

4. The device of Claim 3, wherein the interferometric mask is configured such that a color of light reflected from the light incident side of the interferometric mask substantially matches a color of the photovoltaic active layer visible in regions adjacent the conductor.

5. The device of Claim 3 or 4, wherein the interferometric mask is configured such that the reflectivity of the interferometric mask is less than 10%.

6. The device of any of Claims 3-5, wherein the conductor comprises a bus connecting electrodes for a plurality of photovoltaic cells in an array.

7. The device of any of Claims 3-6, wherein the conductor comprises an electrode in electrical contact with the photovoltaic active layer.

8. The device of any of Claims 3-7, wherein the interferometric mask comprises an absorber over an optical resonant cavity over the conductor.

9. The device of Claim 8, wherein the optical resonant cavity comprises an air gap formed by posts separating the absorber from the conductor.

10. The device of Claim 9, wherein a height of the air gap is between about 450 Å and 1600 Å.

11. The device of Claim 8, wherein the optical resonant cavity comprises a layer of dielectric material.

12. The device of Claim 11, wherein the thickness of the dielectric material is between about 300 Å and 1000 Å

13. The device of Claims 11 or 12, wherein the dielectric layer has an index of refraction between about 1 and 3.

14. The device of any of Claims 11-13, wherein the dielectric layer is a blanket layer extending across the photovoltaic device.

15. The device of any of Claims 8-14, further comprising a passivation layer over the absorber.

16. The device of Claim 15, wherein the passivation layer comprises silicon dioxide.

17. The device of any of Claims 3-16, wherein the photovoltaic active layer is selected from the group consisting of single crystal silicon, amorphous silicon, germanium, III-V semiconductor, copper indium gallium selenide, cadmium telluride, gallium arsenide, indium nitride, gallium nitride, boron arsenide, indium gallium nitride, and tandem multi-junction photovoltaic materials.

18. The device of Claim 3-17, wherein the photovoltaic active layer comprises a thin film photovoltaic material.

19. The device of Claim 18, wherein the thin film is formed over a back side of a transparent substrate, over the interferometric mask and over the conductor.

20. The device of Claim 19, wherein the conductor is in electrical contact with the photovoltaic material through a transparent conducting oxide (TCO).

21. The device of Claim 18, wherein the thin film is formed over the back side of a transparent substrate and over the conductor, and the interferometric mask is formed and patterned over the light incident side of the transparent substrate.

22. The device of any of Claims 3-21, wherein the photovoltaic active layer comprises an interferometrically enhanced photovoltaic device.

23. The device of any of Claims 8-16, wherein the interferometric mask comprises an active MEMS device.

24. The device of Claim 23, wherein the absorber acts as a movable electrode.

25. The device of Claim 1, wherein:
the means for generating the electrical current comprises a photovoltaic material;
the means for conducting comprises a conductor on a front side of the photovoltaic material; and
the means for interferometrically masking comprises an interferometric mask in front of the photovoltaic material and the conductor, wherein the interferometric mask comprises
a reflective surface in front of the photovoltaic material;
an optical resonant cavity in front of the reflective surface; and
an absorber in front of the optical resonant cavity,
wherein a visible color across the front side of the photovoltaic device, including portions of the photovoltaic material and the metallic conductor, is substantially uniform.

26. The device of Claim 25, wherein the optical resonant cavity comprises a composite of two or more of an air gap, a transparent conducting layer and a transparent dielectric layer.

27. The device of Claim 25, wherein one or more layers of the optical interferometric mask and the conductor is screen printed.

28. The device of Claim 25, wherein the conductor is transparent.

29. The device of Claim 25, wherein the reflective surface is defined by the conductor.

30. The device of any of Claims 1-29, wherein the means for interferometrically masking is configured such that little or no incident visible light is reflected from the light incident side of the means for interferometrically masking so as to appear black from a normal viewing angle.

31. A method of manufacturing a photovoltaic device having a front side on which light is incident and a back side opposite the front side, the method comprising masking reflections from the photovoltaic device by forming an interferometric modulator over the front side of the photovoltaic device.

32. The method of Claim 31, wherein the photovoltaic device comprises a photovoltaic active layer, a patterned front side conductor and a backside conductor.

33. The method of Claim 32, wherein forming the interferometric modulator comprises
forming a plurality of layers over a front side of the photovoltaic device; and
patterning one or more of the plurality of layers to define the interferometric modulator covering the patterned front side conductor.

34. The method of Claim 33, wherein forming the plurality of layers comprises forming an absorber and an optical resonant cavity configured to reflect visible light substantially matching a visible spectrum reflected by exposed portions of the photovoltaic active layer.

35. The method of Claim 34, wherein forming the optical resonant cavity comprises forming a dielectric layer.

36. The method of Claim 35, wherein patterning comprises patterning the absorber and the dielectric layer.

37. The method of Claim 35, wherein patterning comprises patterning the absorber to follow a pattern of the patterned front side conductor and leaving the dielectric layer as a blanket layer.

38. The method of any of Claims 33-37, wherein patterning comprises forming the interferometric modulator coextensively with the front side conductor.

39. The method of any of Claims 33-36 and 38, further comprising patterning the front side conductor simultaneously with patterning one or more of the plurality of layers.

40. The method of any of Claims 33-37, wherein forming and patterning the plurality of layers comprises screen printing the plurality of layers in a pattern that follows the patterned front side conductor.

41. The method of Claim 34, wherein forming the optical resonant cavity comprises forming an air gap and a spacer.

42. The method of Claim 32, wherein the photovoltaic device is formed on a transparent substrate having opposing sides such that the front side conductor and the interferometric modulator are formed on opposing sides of the transparent substrate.

43. The method of any of Claims 31-42, wherein forming the interferometric modulator comprises forming an absorber, an optical resonant cavity, and a reflective conductor, wherein the absorber is patterned to follow a pattern of the reflective conductor.

44. The method of any of Claims 31-43, wherein the interferometric modulator is configured to appear black.
